# EUROPEAN PATENT SPECIFICATION

(11) **EP 1 123 423 B1**
(45) Date of publication and mention of the grant of the patent: **01.08.2007**
(21) Application number: 99949661.5
(22) Date of filing: 15.09.1999
(51) Int. Cl.: C23C 16/24

(54) **HIGH RATE SILICON DEPOSITION METHOD AT LOW PRESSURES**
VERFAHREN ZUM AUFBRINGEN VON SILIZIUM MIT HOHER RATE BEI NIEDRIGEN DRUCK
PROCEDE DE DEPOT DE SILICIUM A FORT DEBIT SOUS PRESSION REDUITE

(30) Priority: 16.09.1998 US 100594 P
(43) Date of publication of application: 16.08.2001
(73) Proprietor: Applied Materials, Inc., Santa Clara, CA 95054 (US)
(72) Inventor: COOK, Robert, C., Livermore, CA 94550 (US); BRORS, Daniel, L., Livermore, CA 94550 (US)
(74) Representative: Powell, Stephen David
(86) International application number: PCT/US1999/021200
(87) International publication number: WO 2000/015868

(56) References cited:
- US-A- 4 401 687
- US-A- 4 976 996
- US-A- 5 551 985
- PATENT ABSTRACTS OF JAPAN vol. 1997, no. 01, 31 January 1997 (1997-01-31) & JP 08 236458 A (SUMITOMO SITIX CORP), 13 September 1996 (1996-09-13)
- PATENT ABSTRACTS OF JAPAN vol. 012, no. 103 (C-485), 5 April 1988 (1988-04-05) & JP 62 230979 A (CANON INC), 9 October 1987 (1987-10-09)
- PATENT ABSTRACTS OF JAPAN vol. 013, no. 021 (C-560), 18 January 1989 (1989-01-18) & JP 63 223178 A (KONICA CORP), 16 September 1988 (1988-09-16)
- PIERSON H.O., Handbook of Chemical Vapor Deposition, Noyes Publications, Park Ridge, New Jersey, USA, (1992), pages 184-185, XP002924655.

## Description

The present invention relates generally to methods for chemical vapor deposition (CVD) of undoped and doped silicon, and more particularly to a method for CVD of undoped and doped silicon employing a novel combination of flow rate, temperature and pressure to achieve improved film properties at a high rate of deposition at low pressure.

Amorphous, polycrystalline and epitaxial silicon are used in the manufacturing of semiconductor devices and deposited onto substrates (i.e. wafers) by chemical vapor deposition. Such processes are carried out in a variety of commercially available hot wall and cold wall reactors. Deposition is accomplished by placing a substrate in a vacuum chamber, heating the substrate and introducing silane or any similar precursor such as disilane, dichlorosilane, silicon tetrachloride and the like, with or without other gases. Deposition rates of approximately 30 to 200 angstroms (3 to 20nm) per minute are achieved for low pressure processes (less than 1 Torr (133 Pa)) as described in "Polycrystalline Silicon for integrated Circuit Applications" (T. Kamins, Kluwer Academic Publishers, 1988, p. 29). There are also some high pressure processes available (25 to 350 Torr (3.33 to 46.66kPa)) that can achieve deposition rates up to about 3,000 angstroms (300nm) per minute as described in detail in United States Patent Numbers 5,576,059 and 5,607,724 and 5,614,257.

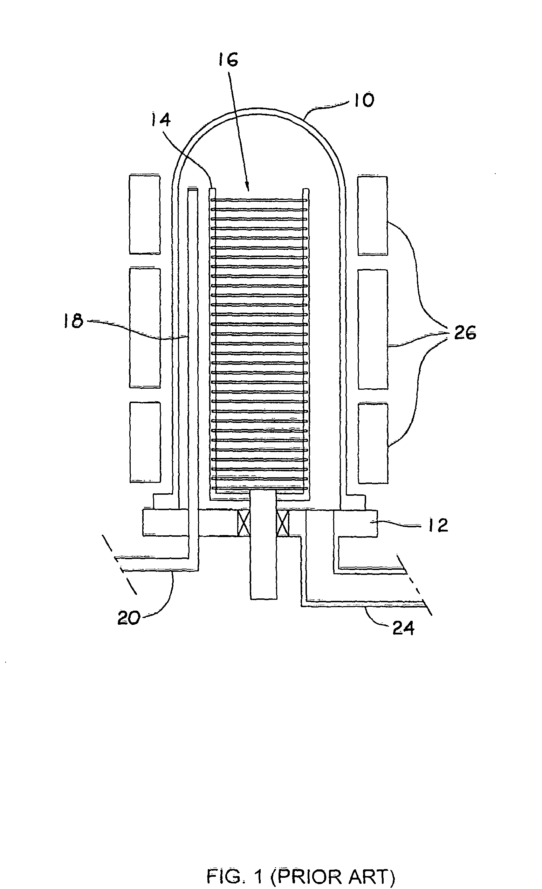

A typical prior art vertical furnace low pressure chemical vapor deposition .(LPCVD) system is depicted in Fig. 1 and includes a chamber consisting of a quartz tube 10 and chamber seal plate 12 into which is inserted a boat 14 for carrying a plurality of substrates 16. Silane or other similar precursor and a carrier gas such as hydrogen and a dopant gas such as phosphine enter the gas injection tube (or tubes) 18 from the gas inlet tube (or tubes) 20 through the chamber seal plate 12. The gases exit the process chamber through the seal plate 12 and out the exhaust port 24. A plurality.of heater elements 26 are separately controlled and adjustable to compensate for the well-known depletion of the feed gas concentration as the gas flows from the gas injection tube 18 to the chamber exhaust port 24. This type of deposition system typically operates in the 200 mTorr(26, 66Pa) to 500 mTorr (66.66 Pa) range. Operating at this low partial pressure of silane, or other similar precursor, results in low deposition rates of the typically 30 to 200 angstroms (3 to 20nm) per minute for deposition of pure silicon, and 5 to 30 angstroms (0.5 to 3nm) per minute if a dopant gas is introduced. Operation at higher concentrations of reactant gases results in non-uniform deposition across the substrates and great differences in the deposition rate from substrate to substrate. Increased flow rates could improve the deposition uniformity at higher pressures, however increased gas flow increases the reactive gas pressure at the injection tube holes causing gas phase nucleation resulting in particles being deposited on the substrates. Other problems associated with this reactor include film deposition on the interior quartz tube 10 and gas injection tube 16. This unwanted deposition decreases the partial pressure of the reactive feed gas concentration near the surface of the substrate 16 resulting in a reduced deposition rate and potential contamination caused when film deposited on the wall of.tube 10 and injector tube 18 flakes off and deposits on the substrates 16. Finally, to offset the depletion of the reactive chemical species from the entrance to the exit of this style reactor, a temperature gradient is determined across the substrate load zone that gives a uniform deposition rate profile. However, this creates a different problem because, in the case of polysilicon deposition, the grain size is temperature dependent, and this temperature gradient causes the polysilicon grain size to vary across the load zone. This variation in grain size from substrate to substrate within a plurality of substrates can cause problems with subsequent patterning of the polysilicon and variations in the electrical performance of integrated circuits.

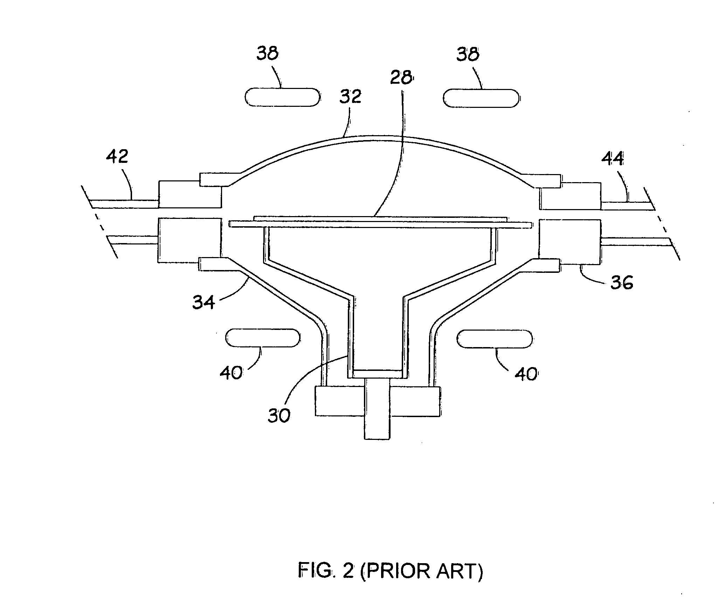

Another prior art reactor is illustrated in Fig. 2 and described in detail in U.S. Patent 5,108,792. A substrate 28 is placed on a rotating substrate carrier 30, enclosed in a vacuum tight chamber having an upper quartz dome 32 and a lower quartz dome 34 and associated chamber wall 36. The substrate 28 is heated by upper lamps 38 and lower lamps 40. Reactant gases are injected through gas input tube 42 and exhausted through exhaust tube 44. This reactor overcomes some of the limitations of the vertical furnace reactor of Fig. 1. The reactor can be operated at higher pressures than vertical LPCVD furnaces and does not have an injector tube and its associated problems. The reactor construction and high rate of deposition at high pressure (typically greater than 10 Torr) is explained in U.S. Patents 5,576,059 and 5, 607, 724 and 5, 614, 257.

Increased deposition rates result in higher machine productivity and more importantly reduce the time the substrates are exposed to high temperatures, i.e. >600°C. Reduced time at high temperatures is important during the fabrication of semiconductor devices as the device sizes become smaller. Elevated temperatures, i.e. >600°C, for any extended time cause unwanted changes in semiconductor device structure. A disadvantage of the prior art high pressure methods is that operating at high pressure can cause a gas phase reaction which can produce particulate contamination on the wafer.

U.S. Patent 5,551,985 by Brors et al. describes a CVD reactor that provides improved uniformity in heating a wafer, and a highly uniform gas flow across the surface of a wafer.

US 6,352,593, US 6,161,837 and US 6,321,680 describe wafer chambers in which related processes may also be used.

US 5,551,985 discloses a CVD reactor including a vacuum chamber having first and second thermal plates disposed therein and two independently-controlled multiple-zone heat sources disposed around the exterior thereof. The first heat source has three zones and the second heat source has two zones. A wafer to be processed is positioned below the first thermal plate and immediately above the second thermal plate, thereby being indirectly heated from above by the first heat source via the first thermal plate and indirectly heated from below by the first zone of the second heat source via the second thermal plate. A thermal ring plate which laterally surrounds the edge of the wafer absorbs heat energy emitted from the second zone of the second heat source and heats the outer edge of the wafer. First and second sensors embedded in the first thermal plate and the thermal ring plate, respectively, measure and provide the respective temperatures thereof to a computer which, in response thereto, adjusts power to the three zones of the first heat source and the two zones of the second heat source to maintain the first thermal plate and the thermal ring plate, respectively, at a constant temperature.

JP 8-236459 discloses increasing the crystal growing speed by the epitaxial growth method by using trichlorosilane as a gaseous starting material and flowing down a carrier gas in a treating furnace at a flow velocity faster than a specific value or in a high-speed laminar flow having a number of inert gas replacing times larger than a specific value so that the reaction temperature can be maintained at a specific value. A crystal layer is grown by epitaxial growth on a single-crystal silicon substrata having a fine pattern in which an impurity is buried and diffused and a crystal axis of <100>0± 1 degree SiC14 is used as a gaseous starting material and a carrier gas is made to flow down in a treating furnace at a flow velocity of 2m/min or in a high-speed laminar flow having a number of inert gas replacing times of 3 times/min. The reaction temperature is maintained at 1,1501 10°C. The reason why the flow velocity of the carrier gas in the treating furnace is specified is to prevent the stagnation of the gaseous starting material by the high-speed laminar flow so that the occurrence of local etching and deposition can be eliminated and the reaction can be stabilized and accelerated.

US 4,976,996 discloses a chemical vapour deposition reactor that comprises an annular reaction zone with means for one or more reactive gases to be passed in single pass radial flow in which there is little lateral diffusion, means for preventing recirculation of reactive gases or reaction products from occurring at any point in the reaction chamber, and means in the reaction chamber for maintaining a laminar gas flow. Rotational means permit the wafer support plates and wafers to be rotated around the central axis of the reaction zone and different gases may be passed over the wafers at different points in the reaction zone such that two or more materials can be deposited on the wafers during a single reactor run.

JP 62-230979 discloses a method of forming a deposited film by applying heat energy under specific conditions to a specific gaseous raw material and gaseous compound containing a forbidden band width expanding element. The gaseous raw material such as Si₂H₅Cl or Ge₂Cl₆ expressed by the formula AaHbXc (where A: Si or Ge; X; halogen element a, b, c; positive integer, and a>=2, c=0), the gaseous compound containing the forbidden band width expanding element such as H₃SiOSH₃ and, if necessary, a valence electron controlling agent, are introduced from gas supply sources to into a deposition chamber and the heat energy is applied to these materials to thermally crack the same, by which the deposited film is formed on the substrate. The residence time of the above-mentioned gaseous raw material and compound in the deposition chamber is adjusted to 0.5sec<=pi<=60sec, and the atmospheric temperature T in the deposition chamber is adjusted to 250°C<=T<=1,200°C.

JP 63-223178 discloses a method of producing an amorphous silicon film by decomposing a silicon compound fed together with a carrier gas by glow discharge at a specified rate of decomposition within a specified residence time so as to attain a specified rate of deposition. A gaseous mixture containing at least a silicon compound such as SiH₄ and a carrier gas such as Ar is fed and the silicon compound is decomposed by glow discharge to form an amorphous silicon film on a substrate. The decomposition by glow discharge is carried out under conditions so as to regulate the rate of decomposition of the silicon compound in the glow discharge space to 20-90% and the average residence time of the gaseous mixture in the glow discharge space to 0.1-1.2sec.

US 4,401,687 discloses a method for plasma deposition of silicon from a silicon source gas. By inclusion of a halogen species in the gas flow stream, thermally induced deposition is inhibited so that plasma decomposition predominates. The silicon gas source may comprise the halogen species, which may alternatively be under separate control. The suppression of thermally induced deposition leads to improved thickness uniformity across the workpieces for significantly increased lifetime or runtime without the conductive plates shorting together.

It is an object of the present invention to provide a method of operating a CVD reactor that provides a further improvement in uniform deposition of silicon.

It is a further object of the'present invention to provide a method of operating a CVD reactor that optimizes the rate and uniformity of deposition of silicon.

It is a still further object of the present invention to provide a method of operating a CVD reactor that results in a high degree of uniformity in deposition from one run to another.

The present invention relates to a method of depositing silicon on a wafer according to claim 1.

The novel combination of process conditions moves the reaction at the wafer surface into the regime where the deposition rate exceeds the crystallization rate, resulting in very small crystal growth and therefore a very smooth polysilicon film with a surface roughness on the order of 5-7 nm for films 2500 angstroms(250nm) thick. The process is configured to operate below what is known as the "transition" temperature, at which level each layer of film is deposited in an amorphous form and then crystallizes as the deposition proceeds because of the lower energy of the polycrystalline structure. As a result, the silicon film is crystalline near the interface between the deposited material and the wafer surface, and amorphous near the top surface of the deposited material, resulting in a much smoother surface than can be achieved with prior art commercial equipment.

An advantage of the present invention is that it results in smoother deposited film surfaces.

A further advantage of the present invention is that it provides a process resulting in improved uniformity in film deposition from batch to batch.

A still further advantage of the present invention is that it provides a method resulting in higher rate deposition of silicon with improved film smoothness and reproducibility between batches.
Fig. 1 illustrates a multiple wafer stack prior art reactor;
Fig. 2 illustrates a single wafer prior art reactor;
Fig. 3 is a flow chart illustrating the steps of the preferred embodiment of the present invention;
Fig. 4 shows a reactor that can be used to implement the method of the present invention;
Fig. 5 is a list of operating parameters according to the present invention;
Fig. 6 is a graph of deposition rate vs temperature;
Fig. 7 is a graph of deposition rate vs pressure;
Fig. 8 is a graph of deposition rate vs silane flow;
Fig. 9 is a plot showing film thickness variations for a number of wafers; and
Fig. 10 is a plot showing the variation in thickness for each of a number of wafers, from an average value.

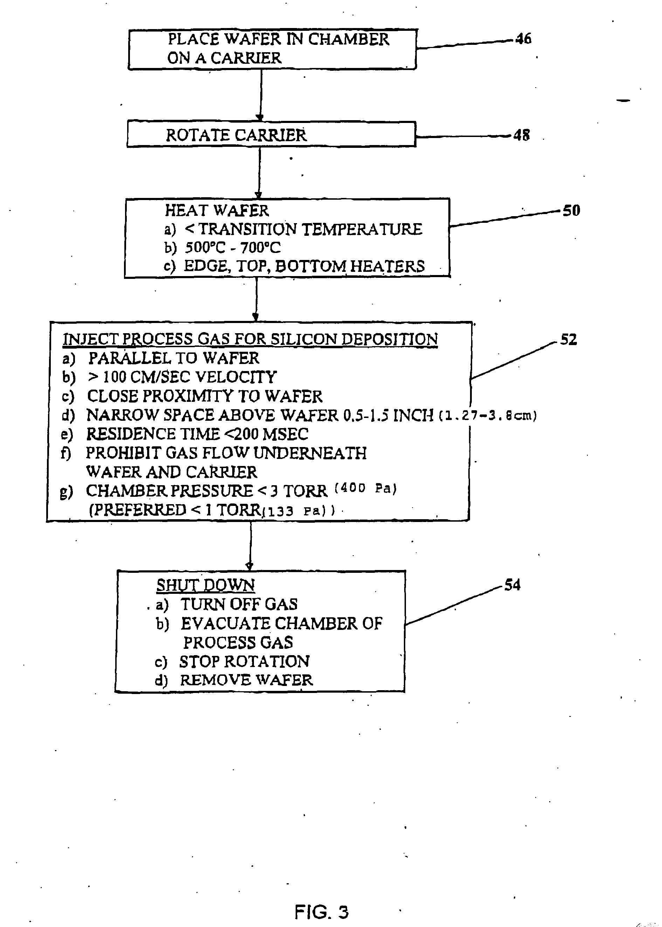

The method of the present invention will now be described in reference to the flow chart of Fig. 3. The process begins by placing a wafer on a carrier in a deposition chamber 46, for deposition of polysilicon and/or amorphous silicon. The carrier is rotated (48) and heated (50). The order of steps 48 and 50 is not significant in that the rotation is for the purpose of enhancing the uniformity of silicon deposition, and may be initiated any time prior to the injection of reactant gases and'then maintained during the deposition. The wafer is preferably heated as uniformly as possible, with heat sources above, below and surrounding the edge of the wafer. The temperature to which the wafer is heated is below a temperature known as the "transition" temperature. The temperature range for silicon deposition being 500°C-700°C. The transition temperature will be more fully-discussed in the following text of the specification.

When the wafer is at the desired temperature, the process gas for silicon deposition is initiated (52). The gas pressure in the chamber is maintained at a selected pressure less than 3 Torr (40OPa) but preferably less than 1 Torr (133Pa), and the gas is preferably injected through a plurality of cooled injector nozzles with injection ports in close proximity to the wafer edge, the nozzles oriented so as to direct the flow parallel and close to the wafer surface. The gas is controlled to flow at a velocity in excess of 10 cm/second and preferably at least 50 to 100 cm/second across the wafer surface in a narrow space confined to the region from the wafer surface to a maxiumum space above the wafer of ½" to 1½" (1.27 to 3.8cm), The benefits and reasons for this will be fully explained in the following text. The velocity of the gas should be sufficient to reduce the gas residence time to less than 500 milliseconds and preferably, less than 200 milliseconds. Subsequent to deposition, the gas is turned off and evacuated from the chamber, the rotation is stopped, and the wafer removed (54).

The results achievable with the method of the present invention as described above in reference to Fig. 3 represent a major improvement in silicon deposition. The term silicon deposition or silicon, etc., will be used in this disclosure as a generic term to include polysilicon, amorphous silicon, and silicon with doping material. As discussed in the section on prior art, previous systems achieved high rates of silicon deposition (1,000-3,000 Å/minute (300nm/minute) by running chambers at relatively high pressures, typically in excess of 10 Torr (1333Pa). Silicon deposition occurring at such high pressures has the disadvantage in that it can cause a gas phase reaction which can produce particulate contamination on the wafer. A major advantage of the present invention is that the method provides a very high deposition rate at very low chamber pressures, resulting in very smooth, uniform and consistent surfaces. With the method of the present invention, deposition rates of 3,000 Å/minute (300nm/minute) are achieved at chamber pressures in the range of 300-700 mTorr (40 to 93kPa). Film uniformity is typically 1%, measured between the center of a 200mm diameter silicon wafer and a point 3 mm from the edge of the wafer. The reasons for this improved performance will now be described in detail, referring to each of the critical parameters of pressure, temperature and gas velocity.

In accordance with the present invention, a wafer/substrate is placed on a rotatable carrier in a vacuum chamber
wherein a high velocity reactant gas for depositing silicon such as silane, and a dopant gas if required, enter the reactor/chamber in relatively close proximity to the rotated, heated wafer. The gas is injected across the wafer at a velocity in excess of 10 cm/second and preferably 50 to 100 cm/second or more, and is confined to a very narrow region above the wafer so as to maximize the gas concentration at the wafer surface. According to the method, the reactant gas is preferably confined to the region extending from the wafer surface to 1/2" (1.27cm), but no more than 1 1/2" (3.8 cm) above the wafer. The high velocity gas stream passing across the wafer surface has the effect of thinning what is known as a "boundary layer" immediately above the wafer. The boundary layer is a region wherein unwanted reaction by-products collect. This layer normally slows the rate of incidence of reactant gas, and thereby slows the rate of deposition. The high velocity gas stream of the present invention sweeps out the unwanted by-products, thinning the boundary layer, allowing a higher rate of desired reactant gas to reach the wafer surface, i.e., resulting in a further increase in the relative concentration of the desired reactant species and reduced incorporation of unwanted reaction by-products in the deposited film.

The combination of elements of the method of the present invention are selected to achieve a more uniform, smooth film. For example, the rapid gas flow described above, in combination with a chamber pressure of about 260 mTorr(35Pa) and a process temperature about 650°C changes the character of the deposition from that of the prior art, moving it into a regime where the reaction is occurring below what is known as a "transition" temperature where the deposition rate exceeds the crystallization rate, providing the benefit of an unusually small amount of crystal growth. The result is a very smooth polysilicon film with a surface roughness on the order of 5-7 nm for films 2,500 Å (250nm) thick. In contrast, the nominal surface roughness using a conventional prior art method is approximately 70 nm as noted in the book "Polycrystalline silicon for Integrated Circuit Applications" by Ted Kamins, page 54.

The nature and background of the phenomenon known as the "transition" temperature will now be described in further detail, and how the method of the present invention provides for operation in this region.

In prior art methods of chemical vapor deposition (CVD) of silicon, during the CVD deposition of silicon at a given pressure, there is a transition temperature that when exceeded will deposit a polycrystalline structure as the deposition proceeds. In such a case, the underlying silicon atoms are unlikely to continue rearranging after they have been covered by further layers of deposited silicon atoms. This is an undesirable result, causing a rough film surface. However, in films deposited slightly below the transition temperature, each layer of the film is deposited in an amorphous form and crystallizes as the deposition proceeds because of the lower energy of the polycrystalline structure. Nucleation of crystallites is most likely to occur by heterogeneous nucleation at the lower silicon-silicon dioxide interface. Crystallization of the amorphous silicon proceeds from these initial nuclei, with the crystalline region propagating upward into the film by solid-phase epitaxial growth. When the crystallization rate is less than the deposition rate, only the lower portion of the film (starting from the silicon-silicon dioxide interface) crystallizes during deposition, even though the crystallization process continues during the subsequent heating that occurs after the deposition is terminated by shutting off the silane flow. Thus, the silicon film can be crystalline near the interface and amorphous near the top surface resulting in a very smooth surface texture that is five to ten times smoother than the typical values obtained from conventional polysilicon deposited films carried out in presently available commercial equipment. Although it is known that operation below the transition temperature can result in a smooth film surface, prior art equipment and methods do not allow such operation in a practical application because the deposition rate is very slow. According to the prior art, high deposition rates of 3,000 Å/minute (300nm/minute) are only possible with chamber pressures above 10 Torr (1333 Pa). In contrast, the method of the present invention provides a combination of elements, including rapid application of reactant gas and removal of unwanted by-products, reducing the boundary layer, operation between 500°C-700°C and at a pressure less than 3 Torr (40OPa) that results in operation below the transition temperature at a very high deposition rate in a range including 3,000 Å/minute (300nm/minute). The non-uniformity of the deposited silicon layer is less than 1.5%, measured between the center of the wafer and a point 3mm from the edge of a 200mm diameter wafer. The surface roughness is in the order of 5-7 nm for a film 2,500 Å (250 nm) thick, deposited at a chamber pressure of 1 Torr (133 Pa) or less.

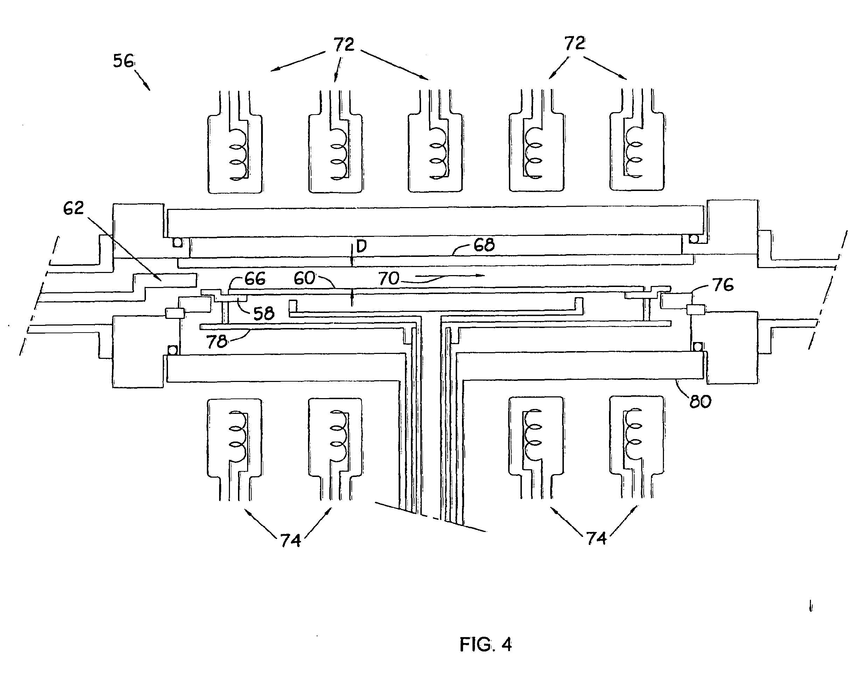

The development of the method of the present invention was accomplished through use of a reactor similar to that shown in the cross-sectional view of Fig. 4. The structure of this apparatus is described in detail in U.S. Patent 5, 551, 985. According to the method, a reactant gas is injected in close proximity to the edge of the wafer, and directed across and parallel to the wafer surface at a high velocity, confined to a narrow region above the wafer. Fig. 4 shows a reactor 56 having a rotatable susceptor 58 upon which is placed a wafer 60. A gas injector apparatus 62 including a plurality of nozzles with jets/openings, is positioned in close proximity to the wafer edge 66, and is oriented to direct a flow of reactant gas across and parallel to the wafer 60. The gas is further confined to a narrow region of width D above the wafer surface by a thermal plate 68 positioned over the wafer. By experiments with the positioning of plate 68, it was determined that the optimum gap D lies between 1/2" (1.27cm) and 1 1/2" (3.8cm). Similarly by experiment, the speed of gas flow from injector 62 across the wafer was found to optimally exceed 50 to 100 cm/second in the direction indicated by arrow 70, for the purposes of optimum reactant gas supply to the wafer surface and removal of reaction by-products according to the method described above.

According to the order of operations described in reference to Fig. 1, the substrate/wafer 60 is first placed on a carrier 58 and then brought to an operating temperature between 500°C and 700°C. Typically, the apparatus of Fig. 1 can reach the temperature in about 20 seconds. The apparatus as shown in Fig. 4 includes heaters 72 above, 74 below, and a heat block 76 surrounding the carrier. This combination provides uniform heating of the wafer 60. The carrier is then rotated at a speed of approximately 5 RPM, and the reactant gas is injected. The method of the present invention minimizes deposition on chamber surfaces by specifying that the reactant gas be confined to a narrow region above the substrate. The apparatus of Fig. 4 further assists in this objective by blocking reactant gas from passing underneath the substrate. This is accomplished by injecting a non-reactive gas (argon) at a low pressure under the substrate, between thermal plate 78 and lower quartz window 80. The details of the apparatus construction are fully described in U.S. Patent 5,551,985.

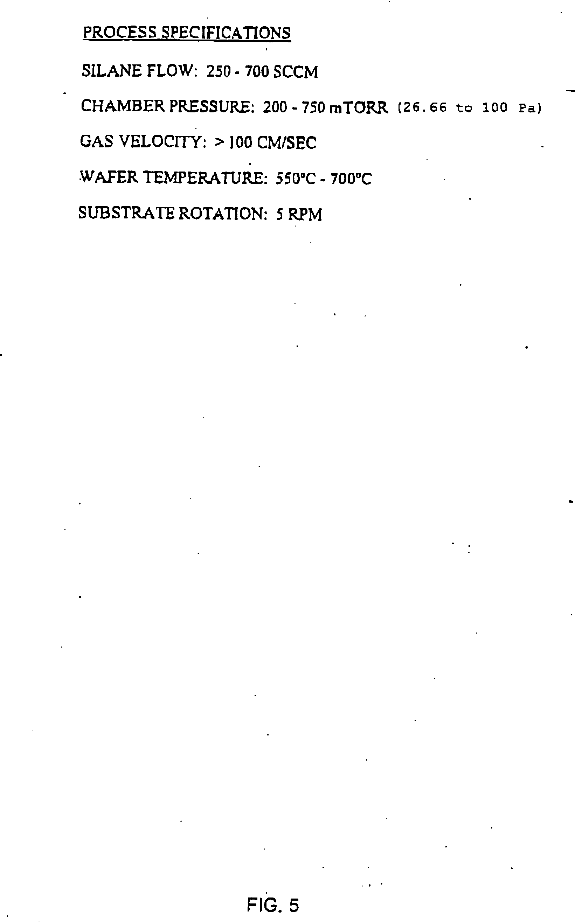

The preferred specifications for the method according to the present invention are listed in Fig. 5, including a silane flow rate in the range of 250-700 sccm, a chamber pressure in the range of 200-750 mTorr (26.66-100Pa), a gas velocity in excess of 100 cm/second confined to 1/2" (1.27cm) over the wafer yielding a gas residence time of less than 200 msec, a wafer uniformly heated to a temperature in the range of 550°C-700°C, and wafer rotation at a preferred rate of 5 RPM. Other rotation speeds are also included in the present invention.

Other factors that contribute to the performance of the method applied to the apparatus of Fig. 4 include the plurality of water-cooled injector nozzles, prevention of reactant gas flow underneath the wafer, gas nozzles/jets directed across and positioned close to the ends of the wafer, and uniform wafer heating with heaters above, below, and around the edge of the wafer.

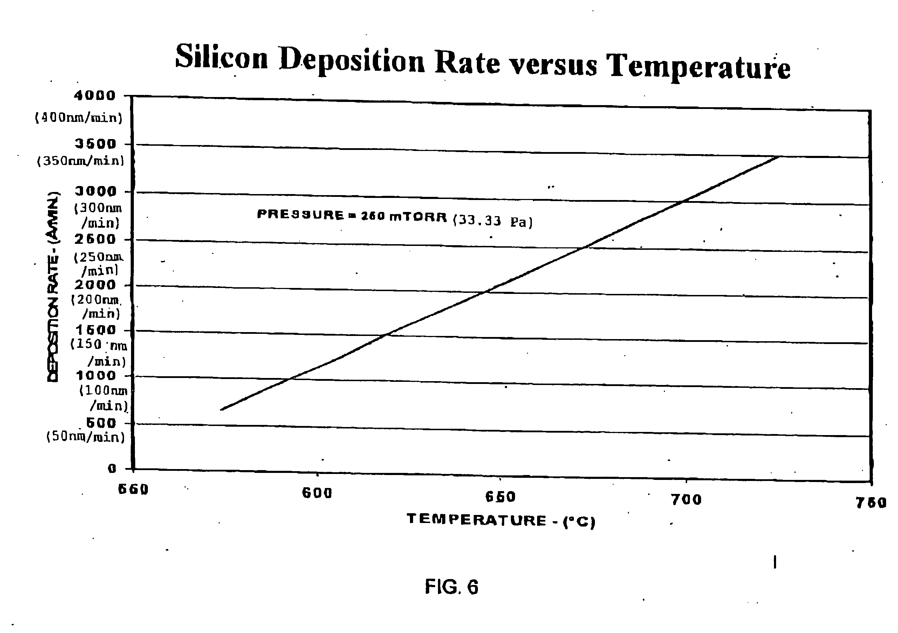

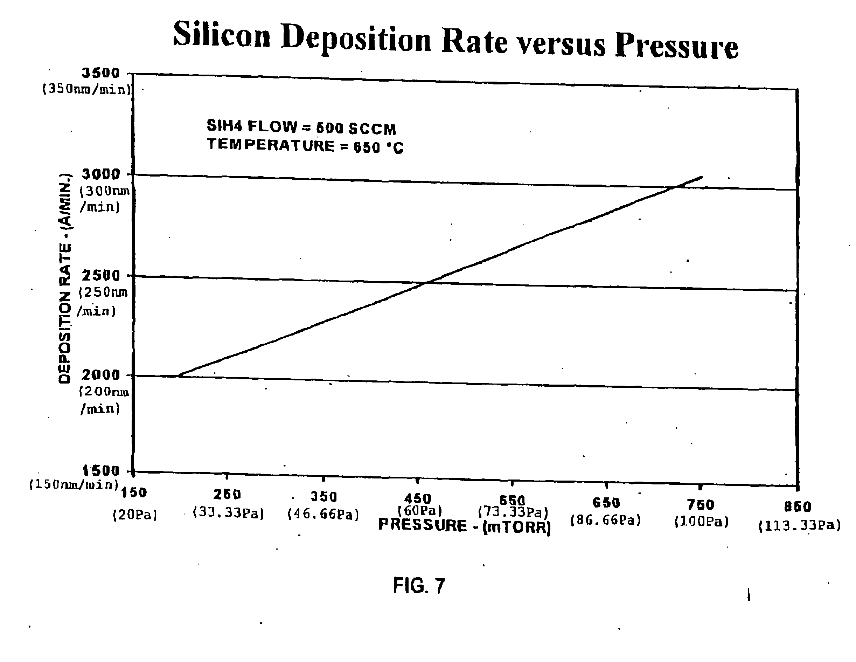

Various performance factors are illustrated in the graphs of Figs. 6-10. Fig. 6 shows the silicon deposition rate versus wafer temperature with a chamber pressure of 250 mTorr. (33.33Pa). It can be seen that the deposition rate is a rapid function of temperature at 250 mTorr (33.33Pa) and therefore fairly critical. Fig. 7 shows the deposition rate versus chamber pressure at a temperature of 650°C.

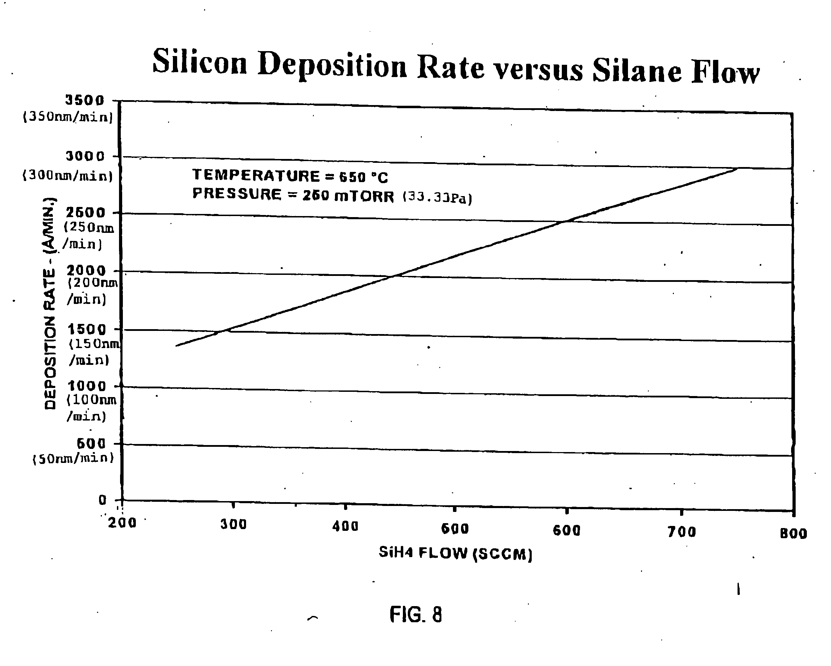

Fig. 8 shows the deposition rate as a function of silane flow, which is proportional to the gas velocity over the wafer.

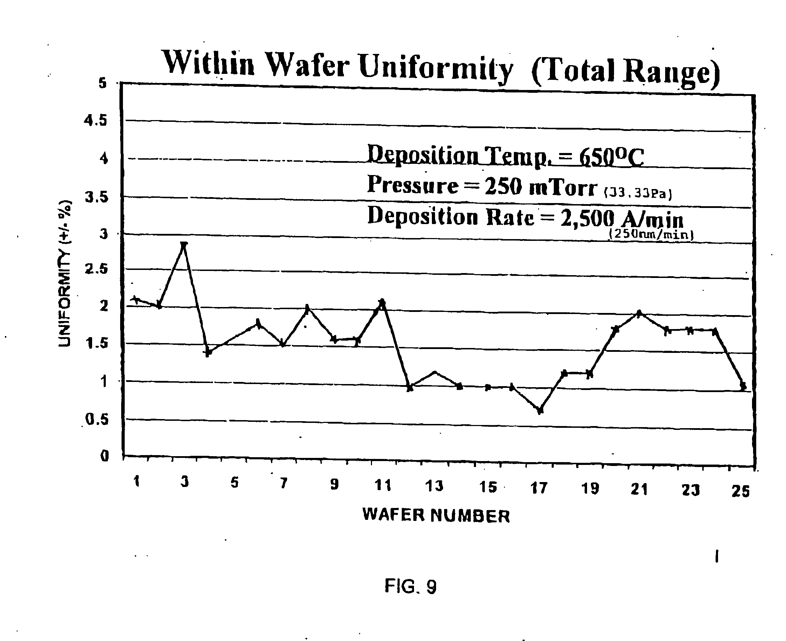

Fig. 9 is a plot of the deposition thickness variation within each wafer, for 25 wafers. The maximum film thickness variation as shown is approximately 2.9%, with an average variation around 1.5%.

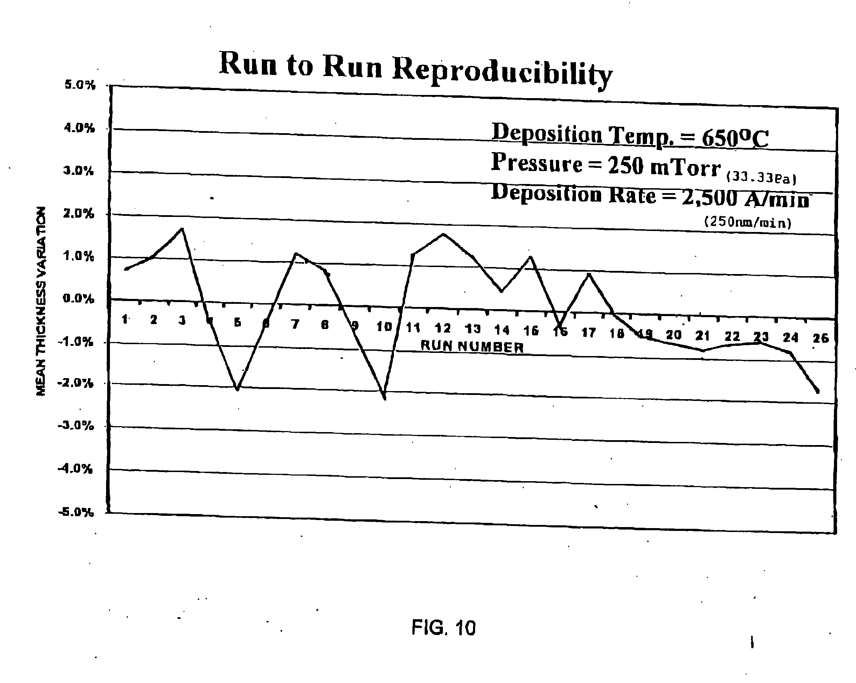

Fig. 10 shows the variation in average film deposition thickness from one wafer to another for 25 wafers. The maximum deviation, from the average for the batch is about 2%.

Although the present invention has been described above in terms of a specific embodiment, it is anticipated that alterations and modifications thereof will no doubt become apparent to those skilled in the art. It is therefore intended that the following claims be interpreted as covering all such alterations and modifications as fall within the scope of the invention.

## Claims

1. A method of depositing silicon on a wafer including the steps of:
(a) placing (46) a wafer (60) on a carrier in a deposition chamber; and then
(b) rotating (48) said carrier about a central axis of said carrier for equalizing distribution of a process gas over said wafer;
(c) heating (50) said wafer to a temperature of 500°C to 700°C; and then
(d) injecting (52) said process gas substantially parallel to a surface of said wafer at a velocity of at least 10 cm/sec with a pressure in said deposition chamber at a value less than 3 torr (400Pa), wherein said chamber pressure is maintained in the range from 200-750 mTorr (26.66-100 Pa) while said process gas is being introduced into said chamber.

2. A method as recited in claim 1, wherein said wafer is heated to a temperature in the range of 650°C to 700°C.

3. A method as recited in claim 1 or 2, wherein said velocity is adjusted to cause an average gas resident time of said process gas in said deposition chamber of less than 500 milliseconds.

4. A method as recited in any preceding claim, wherein said process gas is introduced into said chamber at a flow rate in the range of 250 to 700 sccm.

5. A method as recited in any preceding claim, wherein said process gas is introduced to a plurality of gas nozzles configured to extend toward an edge of said wafer (60).

6. A method as recited in claim 5, wherein said gas nozzles are water-cooled.

7. A method as recited in claims 5 or 6, wherein said gas nozzles are configured to cause said gas stream to be directed at said surface of said wafer (60).

8. A method as recited in claim 7, wherein a distance between the wafer (60) and an upper heat shield (68) is less than 11/2 inches (3.8cm).

9. A method as recited in any of claims 5 to 8, wherein a plurality of reactant gases enter through a plurality of separate nozzles for each reactant gas.

10. A method as recited in claim 9, wherein a distance between the wafer (60) and an upper heat shield (68) is less than 1/2 inch (1.52cm).

11. A method as recited in any of claims 1 to 4, wherein a dopant gas is introduced to a gas nozzle configured to extend toward an edge of said wafer (60).

12. A method as recited in any preceding claim, wherein said process gas passing across said wafer (60) is confined to within 11/2 inches (3.8cm) above said wafer (60).

13. A method as recited in any preceding claim, wherein said process gas passing across said wafer is confined to within 1 inch (2.54 cm) above said wafer (60).

14. A method as recited in any preceding claim, wherein said process gas passing across said wafer is confined to within 1/2 inch (1.27cm) above said wafer (60).

## Patentansprüche

1. Verfahren zum Abscheiden von Silizium auf einem Wafer unter Einschluss folgender Schritte:
a) das Platzieren (46) eines Wafers (60) auf einem Träger in einer Abscheidekammer; und danach
b) Drehen (48) des Trägers um eine Mittelachse des Trägers zum Ausgleichen der Verteilung eines Prozessgases über dem Wafer;
c) Erhitzen (50) des Wafers auf eine Temperatur von 500°C bis 700°C; und danach
d) Injizieren (52) des Prozessgases im Wesentlichen parallel zu einer Oberfläche des Wafers mit einer Geschwindigkeit von wenigstens 10 cm pro Sekunde mit einem Druck in der Abscheidekammer bei einem Wert von weniger als 3 Torr (400 Pa), wobei der Druck in der Kammer in dem Bereich von 200 mTorr bis 750 mTorr (26,66 Pa bis 100 Pa) aufrecht erhalten wird, während das Prozessgas in die Kammer eingeführt wird.

2. Verfahren nach Anspruch 1,
**in welchem** der Wafer auf eine Temperatur in dem Bereich von 650°C bis 700°C aufgeheizt wird.

3. Verfahren nach Anspruch 1 oder 2,
**in welchem** die Geschwindigkeit einjustiert wird, um eine durchschnittliche Verweildauer des Prozessgases in der Abscheidekammer von weniger als 500 Millisekunden zu bewirken.

4. Verfahren nach einem der vorstehenden Ansprüche,
**in welchem** das Prozessgas in die Kammer mit einer Strömungsrate in dem Bereich von 250 bis 700 sccm eingeführt wird.

5. Verfahren nach einem der vorstehenden Ansprüche,
**in welchem** das Prozessgas zu mehreren Gasdüsen zugeführt wird, die so aufgebaut sind, dass sie sich in Richtung einer Kante des Wafers (60) erstrecken.

6. Verfahren nach Anspruch 5,
**in welchem** die Gasdüsen wassergekühlt sind.

7. Verfahren nach einem der Ansprüche 5 oder 6,
**in welchem** die Gasdüsen so aufgebaut sind, dass sie den Gasstrom veranlassen, in Richtung auf die Oberfläche des Wafers (60) gerichtet zu sein.

8. Verfahren nach Anspruch 7,
**in welchem** ein Abstand zwischen dem Wafer (60) und einem oberen Hitzeschild (68) weniger als 1,5 Zoll (3,8 cm) beträgt.

9. Verfahren nach einem der Ansprüche 5 bis 8,
**in welchem** mehrere der Reaktionsgase durch mehrere getrennte Düsen für jedes Reaktionsgas eintreten.

10. Verfahren nach Anspruch 9,
**in welchem** ein Abstand zwischen dem Wafer (60) und einem oberen Hitzeschild (68) weniger als ein halbes Zoll (1,52 cm) beträgt.

11. Verfahren nach einem der Ansprüche 1 bis 4,
**in welchem** ein Dotierungsgas zu einer Gasdüse zugeführt wird, die so aufgebaut ist, dass sie sich in Richtung auf eine Kante des Wafers (60) erstreckt.

12. Verfahren nach einem der vorstehenden Ansprüche,
**in welchem** das Prozessgas über den Wafer (60) streicht und auf einen Bereich innerhalb von 1,5 Zoll (3,8 cm) oberhalb des Wafers (60) begrenzt ist.

13. Verfahren nach einem der vorstehenden Ansprüche,
**in welchem** das über den Wafer streichende Prozessgas auf einen Bereich innerhalb von 1 Zoll (2,54 cm) oberhalb des Wafers (60) begrenzt ist.

14. Verfahren nach einem der vorstehenden Ansprüche,
**in welchem** das über den Wafer streichende Prozessgas auf einen Bereich innerhalb von einem halben Zoll (1,27 cm) oberhalb des Wafers (60) begrenzt ist.

## Revendications

1. Procédé permettant de déposer du silicium sur une plaquette, comportant les étapes consistant à :
(a) placer (46) une plaquette (60) sur un support dans une chambre de dépôt ; puis à
(b) mettre en rotation (48) ledit support autour d'un axe central dudit support pour égaliser la répartition d'un gaz de traitement sur ladite plaquette ;
(c) chauffer (50) ladite plaquette jusqu'à une température comprise entre 500 °C et 700 °C ; puis
(d) injecter (52) ledit gaz de traitement de manière sensiblement parallèle à une surface de ladite plaquette à une vitesse d'au moins 10 cm/s sous une pression, dans ladite chambre de dépôt, inférieure à 3 torrs (400 Pa), dans lequel ladite pression de la chambre est maintenue dans un éventail compris entre 200 et 750 mTorrs (26,66-100 Pa) tandis que ledit gaz de traitement est introduit dans ladite chambre.

2. Procédé selon la revendication 1, dans lequel ladite plaquette est chauffée à une température comprise entre 650 °C et 700 °C.

3. Procédé selon la revendication 1 ou 2, dans lequel ladite vitesse est ajustée pour que le temps de séjour moyen dudit gaz de traitement dans ladite chambre de dépôt soit inférieur à 500 millisecondes.

4. Procédé selon l'une quelconque des revendications précédentes, dans lequel ledit gaz de traitement est introduit dans ladite chambre à un débit compris entre 250 et 700 sccm.

5. Procédé selon l'une quelconque des revendications précédentes, dans lequel ledit gaz de traitement est introduit dans une pluralité de tuyères à gaz configurées pour s'étendre vers un bord de ladite plaquette (60).

6. Procédé selon la revendication 5, dans lequel lesdites tuyères à gaz sont refroidies avec de l'eau.

7. Procédé selon la revendication 5 ou 6, dans lequel lesdites tuyères à gaz sont configurées pour amener ledit flux de gaz à être dirigé vers ladite surface de ladite plaquette (60).

8. Procédé selon la revendication 7, dans lequel une distance entre la plaquette (60) et un écran thermique supérieur (68) est inférieure à 3,8 cm (11/2 pouces).

9. Procédé selon l'une quelconque des revendications 5 à 8, dans lequel une pluralité de gaz de réaction entrent par une pluralité de tuyères séparées pour chaque gaz de réaction.

10. Procédé selon la revendication 9, dans lequel une distance entre la plaquette (60) et un écran thermique supérieur (68) est inférieure à 1,52 cm (1/2 pouces).

11. Procédé selon l'une quelconque des revendications 1 à 4, dans lequel un gaz dopant est introduit dans une tuyère à gaz configurée pour s'étendre vers un bord de ladite plaquette (60).

12. Procédé selon l'une quelconque des revendications précédentes, dans lequel ledit gaz de traitement qui traverse ladite plaquette (60) est limité à 3,8 cm (11/2 pouces) au-dessus de ladite plaquette (60).

13. Procédé selon l'une quelconque des revendications précédentes, dans lequel ledit gaz de traitement qui traverse ladite plaquette est limité à 2,54 cm (1 pouce) au-dessus de ladite plaquette (60).

14. Procédé selon l'une quelconque des revendications précédentes, dans lequel ledit gaz de traitement traversant ladite plaquette est limité à 1,27 cm (1/2 pouce) au-dessus de ladite plaquette (60).
